# EUROPEAN PATENT APPLICATION

(11) **EP 1 693 707 A1**
(43) Date of publication of application: **23.08.2006**
(21) Application number: 06250767.8
(22) Date of filing: 13.02.2006
(51) Int. Cl.: G03F 7/039, G03F 7/09

(54) **Positive resist composition, and patterning process using the same**

(30) Priority: 16.02.2005 JP 2005039360
(71) Applicant: Shinetsu Chemical Co., Ltd., Tokyo 100-0004 (JP)
(72) Inventor: Maeda, Kazunori Shin-Etsu Chemical Co., Ltd., Jyoetsu-shi Niigata-ken (JP); Takeda, Takanobu Shin-Etsu Chemical Co., Ltd., Jyoetsu-shi Niigata-ken (JP); Fukuda, Eiji Shin-Etsu Chemical Co., Ltd., Jyoetsu-shi Niigata-ken (JP); Watanabe, Satoshi Shin-Etsu Chemical Co., Ltd., Jyoetsu-shi Niigata-ken (JP)
(74) Representative: D'Arcy, Julia

(57) **Abstract**

The present invention provides a positive resist composition wherein at least a polymer included in a base resin has a repeating unit with an acid labile group having absorption at the 248 nm wavelength light and the repeating unit is included with a ratio of 1 - 10 % of all repeating units of polymers included in the base resin. There can be provided a positive resist composition with equal or higher sensitivity and resolution than those of conventional positive resist compositions, and in particular, by which a pattern profile on a substrate with high reflectivity is excellent and generation of a standing wave and line edge roughness are reduced.

## Description

### BACKGROUND OF THE INVENTION

### Field of the Invention:

The present invention relates to a positive resist composition like a chemically amplified positive resist composition suitable as a micropatterning material, especially for the VLSI manufacture, which are characterized by a high alkali dissolution-rate contrast before and after exposure, high sensitivity, high resolution, in addition, especially, an excellent pattern profile on a substrate with high reflectivity, reduction of generating a standing wave, and reduced line edge roughness.

### Description of the Related Art:

It has been needed to make a pattern rule finer along with a tendency of integration and speed of LSI becoming higher in recent years, and a deep-ultraviolet lithography is considered as excellent as an ultra-fine processing technology of the next generation. Processing of 0.5 µm or less can be done with deep-ultraviolet lithography.

A chemically amplified resist composition developed recently using acid as a catalyst (for example, see Japanese Patent Publication No. 2-27660 and Japanese Patent Application Laid-open (KOKAI) No. 63-27829) uses high-luminance KrF excimer lasers as a light source of far-ultraviolet ray, and has high sensitivity, high resolution and high dry etching resistance. Therefore, such a resist composition is expected as a desirable resist composition particularly for a deep-ultraviolet lithography having excellent features.

As for a chemically amplified resist composition as mentioned above, the binary-system comprising a base resin and an acid generator, and the ternary-system comprising a base resin, an acid generator and a dissolution inhibitor with an acid labile group have been known.

For example, a resist composition using copolymer of hydroxy styrene and tertiary (meth)acrylate is disclosed (for example, see Japanese Patent Application Laid-open (KOKAI) No. 3-275149 and Japanese Patent Application Laid-open (KOKAI) No. 6-289608). Furthermore, a resist composition using a resin in which homopolymer of hydroxy styrene is protected with acetal is commonly used (for example, see Japanese Patent Application Laid-open (KOKAI) No. 6-194842).

Although these resist compositions have a certain level of resolution, pattern profile after exposure, particularly pattern profile on a substrate with high reflectivity is inferior, and a standing wave is considerably generated.

To solve this problem, a method to add a monomer or a polymer having absorption at the 248 nm wavelength light to a resist composition has been disclosed (for example, see Japanese Patent Application Laid-open (KOKAI) No. 2004-302079).

However, although this method achieves reduction of generating a standing wave, deterioration of resolution is also accompanied, and the method can not yield satisfactory pattern profile. Furthermore, in recent years, as pattern becomes finer rapidly, thickness of a resist film inevitably becomes thinner in parallel. And, in particular, such a problem has become an important issue.

At present, as higher resolution and a thinner film have been required, a resist composition with high sensitivity, high resolution, in addition, in which a pattern profile after exposure is excellent and generation of a standing wave can be reduced, and a method for producing such a resist composition have been required.

### SUMMARY OF THE INVENTION

The present invention was accomplished in view of the aforementioned circumstances, and its object is to provide a positive resist composition with equal or higher sensitivity and resolution than those of conventional positive resist compositions, and in particular, in which a pattern profile on a substrate with high reflectivity is excellent and generation of a standing wave and line edge roughness are reduced.

The present invention was accomplished to achieve the aforementioned object, and there is provided a positive resist composition wherein at least a polymer included in a base resin has a repeating unit with an acid labile group having absorption at the 248 nm wavelength light and the repeating unit is included with a ratio of 1-10% of all repeating units of polymers included in the base resin.

And in this case, it is preferable that the repeating unit with an acid labile group having absorption at the 248 nm wavelength light is represented by a following general formula (1), 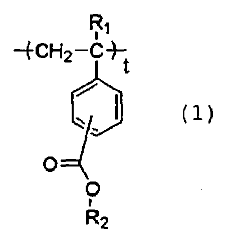 ,wherein R₁ represents a hydrogen atom or a methyl group, R₂ represents a tertiary alkyl group or an alkoxy alkyl group having 4-20 carbon atoms, and t satisfies t>0.

The positive resist composition of the present invention includes such a repeating unit, in particular, an alkoxy carbonyl styrene, thereby the resist composition is characterized by a high alkali dissolution-rate contrast before and after exposure, high sensitivity, high resolution, and especially, in which a pattern profile on a substrate with high reflectivity becomes excellent, and generation of a standing wave and line edge roughness are reduced. And such a positive resist composition of the present invention is particularly suitable as a micropatterning material for the VLSI manufacture.

And, it is preferable that in the positive resist composition of the present invention, the base resin further includes repeating units represented by a following general formula (2), 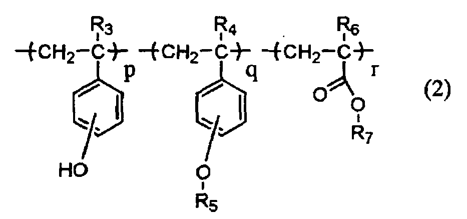 , wherein R₃, R₄ and R₆ independently represents a hydrogen atom or a methyl group, R₅ represents any one of a tertiary alkyl group, an alkoxy alkyl group, an alkoxy carbonyl group and an alkoxy carbonyl alkyl group having 4-20 carbon atoms, R₇ represents a tertiary alkyl group having 4-20 carbon atoms, p satisfies p>0, and q and r satisfy q≧0 and r≧0.

A pattern size, a pattern profile, a standing wave, etc. can be controlled more precisely by choosing properly ratios of these repeating units to be included in the base resin.

In addition, it is preferable that in the positive resist composition according to the present invention, the repeating unit represented by the general formula (1) is included with a ratio of 3-6% of all the repeating units of polymers included in the base resin.

If the repeating unit represented by the general formula (1) is included with a ratio of 3-6% of all the repeating units of polymers included in the base resin, generation of a standing wave and line edge roughness can be reduced, and high sensitivity and high resolution can be achieved.

In addition, it is possible that in the positive resist composition according to the present invention, the base resin has 10-60% transmittance at the 248 nm wavelength light with a film thickness of 10000Å.

As mentioned above, it is possible that in the positive resist composition according to the present invention, the base resin has 10-60% transmittance at the 248 nm wavelength light with a film thickness of 10000Å. Therefore, in particular, generation of a standing wave on a substrate with high reflectivity can be reduced and line edge roughness can also be reduced.

In addition, it is preferable that the positive resist composition according to the present invention further contains an organic solvent and an acid generator to serve as a chemically amplified resist composition.

As mentioned above, if the positive resist composition according to the present invention further contains an organic solvent and an acid generator to serve as a chemically amplified resist composition, even in the case of a low exposure intensity, acid generated upon exposure from an acid generator deprotects an acid labile group in a polymer to change exposed area to be dissolved into a developer, thereby pattern with extreme precision can be formed.

In addition, it is preferable that the positive resist composition of the present invention may contain a dissolution inhibitor further.

By blending a dissolution inhibitor in the positive resist composition of the present invention as described above, the difference of a dissolution rate in the exposed area and the non-exposed area can be enhanced further, and resolution can be improved further.

In addition, it is preferable that the positive resist composition according to the present invention further contains a basic compound.

As mentioned above, if the positive resist composition according to the present invention further contains a basic compound, a diffusion rate of an acid in a resist film can be suppressed and resolution can be further improved.

Furthermore, the present invention provides a patterning process comprising, at least, a step of applying the positive resist composition according to the present invention on a substrate, a step of exposing the applied resist composition to high energy beam after heat-treatment, and a step of developing the exposed resist composition by using a developer.

In the patterning process of the present invention, of course, development may be conducted after heat treatment following exposure, and other various processes, such as an etching process, a resist removing process, a cleaning process etc. may be performed.

As described above, a positive resist composition of the present invention has a repeating unit with an acid labile group having absorption at the 248 nm wavelength light and the repeating unit, in particular, an alkoxy carbonyl styrene is included with a ratio of 1-10% of all repeating units of polymers included in a base resin. Therefore, the resist composition is characterized by a high alkali dissolution-rate contrast before and after exposure, high sensitivity and high resolution. In addition, especially, a pattern profile on a substrate with high reflectivity is excellent, and generation of a standing wave and line edge roughness can be reduced. Consequently, the positive resist composition of the present invention can be preferably used as a micropatterning material, especially for the VLSI manufacture.

### BRIEF DESCRIPTION OF THE DRAWINGS

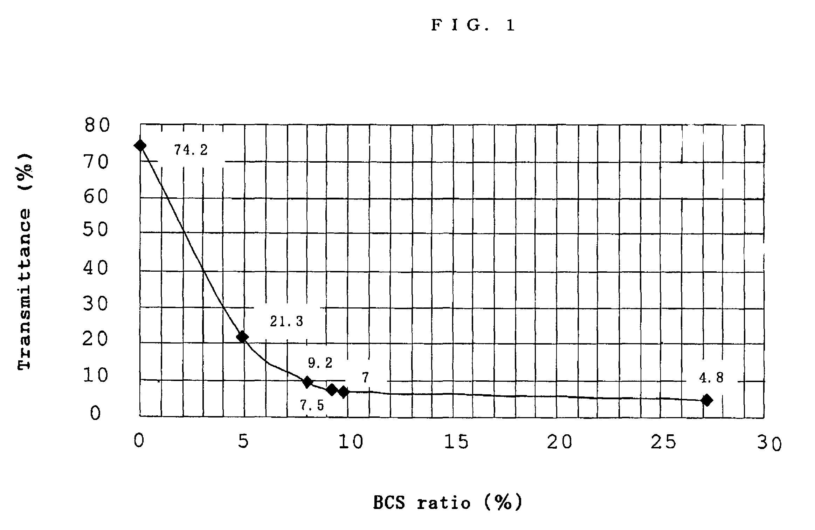

Fig. 1 is a graph showing relationship between a ratio (a BCS ratio) of 4-t-butoxy carbonyl styrene (BCS) and transmittance at the 248 nm wavelength light with a film thickness of 10000Å.

### DESCRIPTION OF THE INVENTION AND A PREFERRED EMBODIMENT

Hereinafter, embodiments of the present invention will be described. However, the present invention is not limited thereto.

The present inventors performed thorough investigations to develop a positive resist composition satisfying both a characteristic having high sensitivity and high resolution, and a characteristic that a pattern profile is excellent and generation of a standing wave and line edge roughness are reduced. Consequently, the inventors have found that a positive resist composition in which a repeating unit with an acid labile group having absorption at the 248 nm wavelength light is included and the repeating unit, in particular, an alkoxy carbonyl styrene is included with a ratio of 1-10% of all repeating units of polymers included in a base resin satisfies both characteristics. Thus, they accomplished the present invention.

Namely, the present invention provides a positive resist composition wherein at least a polymer included in a base resin has a repeating unit with an acid labile group having absorption at the 248 nm wavelength light and the repeating unit is included with a ratio of 1-10% of all repeating units of polymers included in the base resin.

And, in this case, it is preferable that the repeating unit with an acid labile group having absorption at the 248 nm wavelength light is represented by a following general formula (1), 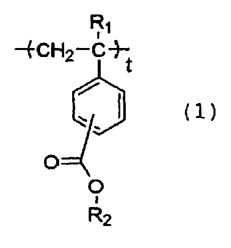 ,wherein R₁ represents a hydrogen atom or a methyl group, R₂ represents a tertiary alkyl group or an alkoxy alkyl group having 4-20 carbon atoms, and t satisfies t>0.

A positive resist composition of the present invention includes such a repeating unit, in particular, alkoxy carbonyl styrene. Thereby, the resist composition is characterized by having a considerably high alkali dissolution-rate contrast before and after exposure, and having equal or higher sensitivity and resolution than those of conventional positive resist compositions. Furthermore, besides such a characteristic, the resist composition is also characterized by an excellent pattern profile, in particular, on a substrate with high reflectivity, reduced generation of a standing wave and reduced line edge roughness.

Consequently, the positive resist composition of the present invention can be preferably used as a micropatterning material, especially for the VLSI manufacture.

And, in the positive resist composition according to the present invention, it is preferable that the base resin further includes repeating units represented by a following general formula (2), 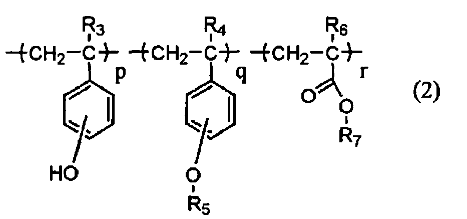 ,wherein R₃, R₄ and R₆ independently represents a hydrogen atom or a methyl group, R₅ represents any one of a tertiary alkyl group, an alkoxy alkyl group, an alkoxy carbonyl group and an alkoxy carbonyl alkyl group having 4-20 carbon atoms, R₇ represents a tertiary alkyl group having 4-20 carbon atoms, p satisfies p>0, and q and r satisfy q≧0 and r≧0.

These repeating units influence alkali dissolution-rate contrast etc. at exposure. Therefore, by selecting properly respective ratios of these repeating units to be included in the base resin, a pattern size, a pattern profile, a standing wave, etc. can be controlled more precisely.

In the above general formulae (1) and (2), R₂, R₅ and R₇ are acid labile groups.

Although a tertiary alkyl group for R₂, R₅ and R₇ are selected variously, the group represented by the following general formulae (3) and (4) is particularly preferable.

The following is a group represented by the general formula (3). 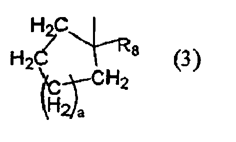 (In the formula, R₈ represents a methyl group, an ethyl group, an isopropyl group, a cyclohexyl group, a cyclopentyl group, a vinyl group, an acetyl group, a phenyl group, a benzyl group, or a cyano group. a is an integer of 0-3.)

As a cycloalkyl group of the above general formula (3), a five-member-ring (namely, a=1) is more preferable.

Examples may include: 1-methyl cyclopentyl, 1-ethyl cyclopentyl, 1-isopropyl cyclopentyl, 1-vinyl cyclopentyl, 1-acetyl cyclopentyl, 1-phenyl cyclopentyl, 1-cyano cyclopentyl, 1-methyl cyclohexyl, 1-ethyl cyclohexyl, 1-isopropyl cyclohexyl, 1-vinyl cyclohexyl, 1-acetyl cyclohexyl, 1-phenyl cyclohexyl, 1-cyano cyclohexyl, etc.

Then, the following is a group represented by the general formula (4). 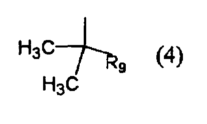 (In the formula, R₉ represents a methyl group, an ethyl group, an isopropyl group, a cyclohexyl group, a cyclopentyl group, a vinyl group, a phenyl group, a benzyl group, or a cyano group.)

Examples of a group represented by the above general formula (4) may include: t-butyl group, 1-vinyl dimethyl, 1-benzyl dimethyl, 1-phenyl dimethyl, 1-cyano dimethyl, etc.

In addition, when R₂ in the general formula (1) represents a group except the above general formulae (3) and (4), R₂ may include: a methoxy ethyl group, an ethoxy ethyl group, n-propoxy ethyl group, iso-propoxy ethyl group, n-butoxy ethyl group, iso-butoxy ethyl group, tert-butoxy ethyl group, a cyclohexyl ethyl group, a methoxy propyl group, an ethoxy propyl group, a methoxy isobutyl group, an isopropoxy isobutyl group, etc.

In addition, when R₅ in the general formula (2) represents a group except the above general formulae (3) and (4), R₅ can be selected variously. However, in particular, it is preferable that R₅ is the group represented by following general formulae (5) and (6). 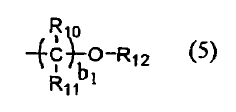 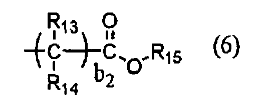 (In the formulae, R₁₀, R₁₁, R₁₂, R₁₃ and R₁₄ represent independently a hydrogen atom, or a linear, branched or cyclic alkyl group having 1-8 carbon atoms. R₁₀ and R₁₁, R₁₀ and R₁₂, or R₁₁ and R₁₂ may form a ring together. In that case, R₁₀, R₁₁ and R₁₂ represent independently a linear or branched alkylene group having 1-18 carbon atoms. R₁₅ represents a linear, branched or cyclic alkyl group having 4-40 carbon atoms. And, b₁ represents a positive number, and b₂ represents 0 or a positive number.)

Here examples of an acid labile group represented by the above general formula (5) may include: a methoxy ethyl group, an ethoxy ethyl group, n-propoxy ethyl group, isopropoxy ethyl group, n-butoxy ethyl group, iso-butoxy ethyl group, tert-butoxy ethyl group, a cyclohexyloxy ethyl group, a methoxy propyl group, an ethoxy propyl group, 1-methoxy-1-methyl-ethyl group, 1-ethoxy-1-methyl-ethyl group, etc.

On the other hand, examples of an acid labile group represented by the above general formula (6) may include: tert-butoxy carbonyl group, tert-butoxy carbonyl methyl group, ethyl cyclopentyl carbonyl group, ethyl cyclohexyl carbonyl group, methyl cyclopentyl carbonyl group, etc.

Examples of a repeating unit represented by the general formula (1) are shown below in structural formulae.

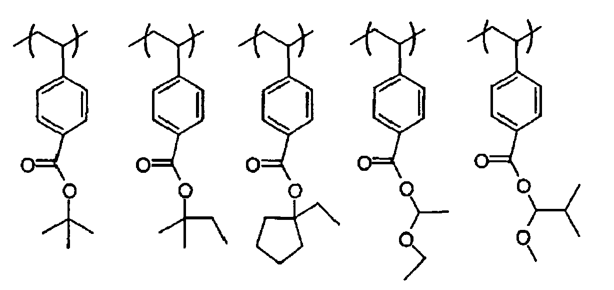

Furthermore, given characteristics of a resist composition, a ratio between a ratio t of the above general formula (1) and p, q and r of the above general formula (2) may be 0.01 ≦ t/(t+p+q+r) ≦ 0.1, more preferably 0.03 ≦ t/(t+p+q+r) ≦ 0.06. By controlling a ratio of t to be in the range, etc., transmittance of a base resin included in the positive resist composition according to the present invention at the 248 nm wavelength light with a film thickness of 10000Å can be controlled. And, the transmittance can be controlled, for example, to be 10-60%, in particular, 10-50%.

In addition, when only one type of a polymer is included in a base resin, t of the above general formula (1) means a ratio of a repeating unit of the general formula (1) in the one type of a polymer. On the other hand, when two or more types of polymers are mixed and included, t means a ratio of a repeating unit of the general formula (1) in the two or more types of polymers.

Furthermore, the preferable range of p, q and r is 0.01 < p/(t+p+q+r) ≦ 0.8, more preferably 0.3 ≦ p/(t+p+q+r) ≦ 0.8, 0 ≦ q/(t+p+q+r) ≦ 0.30, 0 ≦ r/(t+p+q+r) ≦ 0.30.

By including repeating units represented by the above general formula (2), resolution can be adjusted properly. For example, when r and q are small, alkali dissolution-rate contrast becomes small. And, when p is large, alkali dissolution-rate in a non-exposed area becomes large.

Therefore, if values of t, p, q and r are selected properly in the above-mentioned range, a pattern size, a pattern profile and a standing wave can be controlled arbitrarily.

The polymer of the present invention each preferably has a mass average molecular weight (gel permeation chromatography : GPC is used as a mensuration) of 1,000-500,000, more preferably 2,000-30,000. If a mass average molecular weight is in the range, heat resistance of the positive resist composition will be excellent, an alkaline solubility will also be proper, and footing profile after patterning is generally prevented.

Furthermore, in a positive resist composition of the present invention, if the multi-component copolymer of the above general formulae (1) and (2) has a large molecular weight distribution (Mw/Mn), there is a possibility that impurities may be observed on a pattern, or a pattern profile may be degraded after exposure, since polymers with low molecular weight and high molecular weight exist. So, as the pattern rule becomes finer, the influence by a molecular weight or a molecular weight distribution tends to get larger. Accordingly, in order to obtain the resist composition used suitably for a micropatterning size, it is desirable to use a multi-component copolymer with narrow molecular weight distribution of 1.0 - 1.9, preferably 1.0 - 1.5.

The first method for synthesizing these polymers is as follows: A radical initiator is added to an alkoxy alkoxy styrene monomer and an alkoxy carbonyl styrene monomer to be a repeating unit with an acid labile group in an organic solvent to perform heating polymerization. The obtained polymer in an organic solvent is subjected to acid hydrolysis to deprotect an acetal-protecting group, thereby a polymer of a multi-component copolymer comprising a hydroxy styrene and an alkoxy carbonyl styrene can be obtained. In addition, other monomer components can be added in this polymerization. Examples of the organic solvent used for polymerization may include: toluene, benzene, tetrahydrofuran, diethyl ether, dioxane, etc. Examples of the polymerization initiator may include: 2,2'-azobisisobutyronitril, 2,2'-azo bis (2,4-dimethyl valeronitrile), dimethyl 2,2-azo bis (2-methyl propionate), benzoyl peroxide, lauroyl peroxide, etc. The polymerization can be preferably performed by heating at a temperature of 50 °C to 80 °C. The reaction time may be 2 to 100 hours, preferably 5 to 20 hours. As for acid hydrolysis, oxalic acid, acetic acid, etc. can be used as a catalyst, reaction temperature can be -20 - 100°C, preferably 20 - 50°C, and reaction time can be 0.2 - 100 hours, preferably 0.5- 20 hours.

The second method is as follows: A radical initiator is added to an acetoxy styrene monomer and an alkoxy carbonyl styrene monomer to be a repeating unit with an acid labile group in an organic solvent to perform heating polymerization. The obtained polymer in an organic solvent is subjected to deprotection reaction to deprotect an acetyl-protecting group under alkaline condition, thereby a polymer of a multi-component copolymer comprising a hydroxy styrene and an alkoxy carbonyl styrene can be obtained. As for alkaline hydrolysis, ammonia water, triethylamine, etc. can be used as a base, reaction temperature can be -20 - 100°C, preferably 0 - 60°C, and reaction time can be 0.2 - 100 hours, preferably 0.5- 20 hours.

As the third method, living anion polymerization can be carried out. In this method, an alkoxy alkoxy styrene monomer and an alkoxy carbonyl styrene monomer subjected to dehydration and a solvent are used. Examples of the organic solvent to be used may include: hexane, cyclohexane, toluene, benzene, diethyl ether, tetrahydrofuran, etc. To these organic solvents a required amount of anion species is added, then monomers are added to carry out polymerization. Organic metals are used as anion species, and examples of the organic metals may include: alkyllithium, alkylmagnesium halide, sodium naphthalene, alkylated lanthanoide series compounds, etc., in particular, butyllithium and butylmagnesium chloride are preferable. Polymerization temperature is preferably in a range of -100 - 30°C, in order to get more control over polymerization, - 80 - 10°C is more preferable. In addition, deprotection reaction can be carried out under the same process as radical polymerization.

Furthermore, after isolating thus-obtained polymer, an acid labile group represented by the general formula (5) can be introduced into the portion of phenolic hydroxyl group. For example, phenolic hydroxyl group of a polymer is reacted with alkenyl ether compound in the presence of acid catalyst, thereby a polymer in which phenolic hydroxyl groups are partially protected by alkoxy alkyl groups can be obtained.

At this time, as a reaction solvent, nonprotic polar solvent like dimethyl formamide, dimethyl acetamide, tetrahydrofuran, ethyl acetate, etc. are preferable, and which may be used alone or in admixture. Preferable acid as catalyst may include: hydrochloric acid, sulfuric acid, trifluoromethane sulfonate, p-toluenesulfonic acid, methane sulfonic acid, pyridinium p-toluenesulfonic acid, etc., the amount of which is preferably 0.1-10 mole% per 1 mole of hydrogen atoms in all hydroxyl groups of phenolic hydroxyl group of a polymer to be reacted. Reaction temperature may be -20 - 100°C, preferably 0 - 60°C, and reaction time may be 0.2 - 100 hours, preferably 0.5- 20 hours.

In addition, a halogenated alkyl ether compund is reacted with a polymer in the presence of base to obtain a polymer in which phenolic hydroxyl groups are partially protected by alkoxy alkyl groups.

At this time, as a reaction solvent, nonprotic polar solvent like acetonitrile, acetone, dimethyl formamide, dimethyl acetamide, tetrahydrofuran, dimethyl sulfoxide, etc. are preferable, which may be used alone or in admixture. As for base, triethylamine, pyridine, diisopropyl amine, potassium carbonate, etc. are preferable, the amount of which is preferably 10 mole% or more per 1 mole of hydrogen atoms in all hydroxyl groups of phenolic hydroxyl group of a polymer to be reacted. Reaction temperature is -50 - 100°C, preferably 0 - 60°C, and reaction time is 0.5 - 100 hours, preferably 1 - 20 hours.

Furthermore, introduction of an acid labile group represented by the above general formula (6) can be carried out by reacting dialkyl dicarbonate or alkoxy carbonyl alkyl halide with a polymer in a solvent in the presence of base. As a reaction solvent, nonprotic polar solvent like acetonitrile, acetone, dimethyl formamide, dimethyl acetamide, tetrahydrofuran, dimethyl sulfoxide, etc. are preferable, which may be used alone or in admixture.

As for base, triethylamine, pyridine, imidazole, diisopropyl amine, potassium carbonate, etc. are preferable, the amount of which is preferably 10 mole% or more per 1 mole of hydrogen atoms in all hydroxyl groups of phenolic hydroxyl group of an original polymer.

Reaction temperature may be 0 - 100°C, preferably 0 - 60°C, and reaction time may be 0.2 - 100 hours, preferably 1 - 10 hours.

Examples of dialkyl dicarbonate may include: di-tert-butyl dicarbonate, di-tert-amyl dicarbonate, etc. Examples of alkoxy carbonyl alkyl halide may include: tert-butoxy carbonyl methyl chloride, tert-amyloxy carbonyl methyl chloride, tert-butoxy carbonyl methyl bromide, tert-butoxy carbonyl ethyl chloride, etc.

In addition, it is preferable that a positive resist composition of the present invention further contains an organic solvent, an acid generator, a dissolution inhibitor, a basic compound, a surfactant, etc. besides the above-mentioned base resin. If the positive resist composition further contains an organic solvent and an acid generator to serve as a chemically amplified resist composition, acid generated upon exposure from an acid generator deprotects an acid labile group in a polymer to change exposed area to be dissolved into a developer, thereby pattern with extreme precision can be formed. Furthermore, if the positive resist composition further contains a dissolution inhibitor, the difference of the dissolution rate in the exposed area and the non-exposed area can be enhanced further, and a resolution can be improved further. And, if the positive resist composition further contains a basic compound, a diffusion rate of an acid in a resist film can be suppressed and a resolution can be further improved. Furthermore, if the positive resist composition further contains a surfactant, an application property to a substrate can be improved.

Organic solvents used for the positive resist composition of the present invention can be any organic solvents in which a base resin, an acid generator and other additives can be dissolved. Examples of such an organic solvent may include: butyl acetate, amyl acetate, cyclohexyl acetate, 3-methoxy butyl acetate, methyl ethyl ketone, methyl amyl ketone, cyclohexanone, cyclopentanone, 3-ethoxy ethyl propionate, 3-ethoxy methyl propionate, 3-methoxy methyl propionate, methyl acetoacetate, ethyl acetoacetate, diacetone alcohol, methyl pyruvate, ethyl pyruvate, propylene glycol monomethyl ether, propylene glycol monoethyl ether, propylene glycol monomethyl ether propionate, propylene glycol monoethyl ether propionate, ethylene glycol monomethyl ether, ethylene glycol monoethyl ether, diethylene glycol monomethyl ether, diethylene glycol monoethyl ether, 3-methyl-3-methoxy butanol, N-methyl pyrrolidone, dimethyl sulfoxide, γ-butyrolactone, propylene glycol methyl ether acetate, propylene glycol ethyl ether acetate, propylene glycol propyl ether acetate, methyl lactate, ethyl lactate, propyl lactate, tetramethylene sulfonate, etc. However, they are not limited thereto. Among the above-mentioned organic solvents, propylene glycol alkyl ether acetate and alkyl lactate are preferably used.

These organic solvents may be used alone or in admixture. Example of a preferable mixed solvent is an admixture of propylene glycol alkyl ether acetate with alkyl lactate. In addition, an alkyl group of propylene glycol alkyl ether acetate in the present invention may be 1-4 carbon atoms, for example, a methyl group, an ethyl group, a propyl group, etc., and among them a methyl group and an ethyl group are preferable. And, although the propylene glycol alkyl ether acetate comprises 1,2-substitution product and 1,3-substitution product, and in total, three types of isomers in consideration of combination of substituted site, they may be used alone or in admixture. In addition, an alkyl group of the alkyl lactate may be 1-4 carbon atoms, for example, a methyl group, an ethyl group, a propyl group, etc., and among them a methyl group and an ethyl group are preferable.

When propylene glycol alkyl ether acetate is added as an organic solvent, it is preferable that the amount is 50 mass% or more to the total amount of organic solvents.
When alkyl lactate is added as an organic solvent, it is preferable that the amount is 50 mass% or more to the total amount of organic solvents. In addition, when a solvent admixture of propylene glycol alkyl ether acetate and alkyl lactate is used as an organic solvent, it is preferable that the total amount thereof is 50 mass% or more to the total amount of organic solvents. In this case, it is more preferable that a ratio of propylene glycol alkyl ether acetate is 60 - 95 mass% and a ratio of alkyl lactate is 5 - 40 mass%. If propylene glycol alkyl ether acetate is in the range, there is little possibility that problems like deterioration of application property, insufficient solubility, generation of particle and impurities, etc. occur. In addition, if alkyl lactate is in the range, there is little possibility that problems like insufficient solubility, increase of particle and impurities, deterioration of application property due to increase of viscosity, deterioration of preservation stability, etc. occur.

The amount of these organic solvents to be added is preferably 300 to 2,000 parts by mass to 100 parts by mass of a solid content of a chemically amplified positive resist composition, more preferably 400 to 1,000 parts by mass. However, a concentration of an organic solvent is not limited thereto as long as an organic solvent can be used by a conventional application method.

As for an acid generator used for the resist composition of the present invention, any compounds generating acid upon exposure of a high energy beam can be used. Suitable acid generators include sulfonium salt, iodonium salt, sulfonyl diazomethane, N-sulfonyl oxyimide type, etc. Examples of acid generators are shown below, and they can be used alone or in admixture.

A sulfonium salt is a salt of sulfonium cation and sulfonate.

Examples of sulfonium cation may include: triphenyl sulfonium, (4-tert-butoxy phenyl) diphenyl sulfonium, bis (4-tert-butoxy phenyl) phenyl sulfonium, tris (4-tert-butoxy phenyl) sulfonium, (3-tert-butoxy phenyl) diphenyl sulfonium, bis (3-tert-butoxy phenyl) phenyl sulfonium, tris (3-tert-butoxy phenyl) sulfonium, (3,4-ditert-butoxy phenyl) diphenyl sulfonium, bis (3,4-ditert-butoxy phenyl) phenyl sulfonium, tris (3,4-ditert-butoxy phenyl) sulfonium, diphenyl (4-thiophenoxy phenyl) sulfonium, (4-tert-butoxy carbonyl methyl oxy phenyl) diphenyl sulfonium, tris (4-tert-butoxy carbonyl methyl oxy phenyl) sulfonium, (4-tert-butoxy phenyl) bis (4-dimethyl amino phenyl) sulfonium, tris (4-dimethyl amino phenyl) sulfonium, 2-naphthyl diphenyl sulfonium, dimethyl2-naphthyl sulfonium, 4-hydroxy phenyl dimethyl sulfonium, 4-methoxy phenyl dimethyl sulfonium, trimethyl sulfonium, 2-oxocyclohexyl cyclohexyl methyl sulfonium, trinaphthyl sulfonium, tribenzyl sulfonium, etc.

In addition, examples of sulfonate may include: trifluoro methanesulfonate, nonafluoro butane sulfonate, heptadecafluoro octane sulfonate, 2,2,2-trifluoro ethanesulfonate, pentafluoro benzene sulfonate, 4-trifluoro methyl benzene sulfonate, 4-fluorobenzene sulfonate, toluenesulfonate, benzene sulfonate, 4-(4-toluene sulfonyloxy) benzene sulfonate, naphthalene sulfonate, camphor sulfonate, octane sulfonate, dodecylbenzene sulfonate, butane sulfonate, methanesulfonate, etc.

Namely, examples of sulfonium salt may include combination thereof.

An iodonium salt is a salt of iodonium cation and sulfonate.

Examples of iodonium cation may include: aryl iodonium cation like diphenyl iodonium, bis (4-tert-butyl phenyl) iodonium, 4-tert-butoxy phenyl phenyl iodonium, 4-methoxyphenyl phenyl iodonium, etc.

In addition, examples of sulfonate may include: trifluoro methanesulfonate, nonafluoro butane sulfonate, heptadecafluoro octane sulfonate, 2,2,2-trifluoro ethanesulfonate, pentafluoro benzene sulfonate, 4-trifluoro methyl benzene sulfonate, 4-fluorobenzene sulfonate, toluenesulfonate, benzene sulfonate, 4-(4-toluene sulfonyloxy) benzene sulfonate, naphthalene sulfonate, camphor sulfonate, octane sulfonate, dodecylbenzene sulfonate, butane sulfonate, methanesulfonate, etc.

Namely, examples of iodonium salt may include combination thereof.

Examples of sulfonyl diazomethane may include: bissulfonyl diazomethane and sulfonyl carbonyl diazomethane like bis (ethyl sulfonyl) diazomethane, bis (1-methylpropyl sulfonyl) diazomethane, bis (2-methylpropyl sulfonyl) diazomethane, bis (1,1-dimethylethyl sulfonyl) diazomethane, bis (cyclohexylsulfonyl) diazomethane, bis (perfluoro isopropyl sulfonyl) diazomethane, bis (phenylsulfonyl) diazomethane, bis (4-methylphenylsulfonyl) diazomethane, bis (2,4-dimethylphenylsulfonyl) diazomethane, bis (2-naphthylsulfonyl) diazomethane, 4-methylphenylsulfonyl benzoyl diazomethane, tert-butylcarbonyl-4-methylphenylsulfonyl diazomethane, 2-naphthylsulfonyl benzoyl diazomethane, 4-methylphenylsulfonyl-2-naphthoyl diazomethane, methylsulfonyl benzoyl diazomethane, tert-butoxy carbonyl-4-methylphenylsulfonyl diazomethane, etc.

Examples of N-sulfonyl oxyimide type photo acid generator may include: combined compounds of imide structure like succinimide, naphthalene dicarboxyimide, phthalimide, cyclohexyl dicarboxyimide, 5-norbornene-2,3-dicarboxyimide, 7-oxabicyclo [2.2.1]-5-heptene-2,3-dicarboxyimide, etc., and trifluoro methanesulfonate, nonafluoro butane sulfonate, heptadecafluoro octane sulfonate, 2,2,2-trifluoro ethanesulfonate, pentafluoro benzene sulfonate, 4-trifluoro methyl benzene sulfonate, 4-fluorobenzene sulfonate, toluenesulfonate, benzene sulfonate, naphthalene sulfonate, camphor sulfonate, octane sulfonate, dodecylbenzene sulfonate, butane sulfonate, methanesulfonate, etc.

Examples of benzoin sulfonate type photo acid generator may include: benzoin tosylate, benzoin mesylate, benzoin butane sulfonate, etc.

Examples of pyrogallol trisulfonate type photo acid generator may include: compounds obtained by substituting all hydroxyl groups of pyrogallol, phloroglucine, catechol, resorcinol and hydroquinone with trifluoromethane sulfonate, nonafluoro butane sulfonate, heptadecafluoro octane sulfonate, 2,2,2-trifluoro ethanesulfonate, pentafluoro benzene sulfonate, 4-trifluoro methyl benzene sulfonate, 4-fluorobenzene sulfonate, toluenesulfonate, benzene sulfonate, naphthalene sulfonate, camphor sulfonate, octane sulfonate, dodecylbenzene sulfonate, butane sulfonate, methanesulfonate, etc.

Examples of nitro benzyl sulfonate type photo acid generator may include: 2,4-dinitro benzyl sulfonate, 2-nitro benzyl sulfonate, 2,6-dinitro benzyl sulfonate, etc. Examples of sulfonate may include: trifluoro methanesulfonate, nonafluoro butane sulfonate, heptadecafluoro octane sulfonate, 2,2,2-trifluoro ethanesulfonate, pentafluoro benzene sulfonate, 4-trifluoro methyl benzene sulfonate, 4-fluorobenzene sulfonate, toluenesulfonate, benzene sulfonate, naphthalene sulfonate, camphor sulfonate, octane sulfonate, dodecylbenzene sulfonate, butane sulfonate, methanesulfonate, etc. In addition, compounds in which a nitro group of benzyl side is substituted by a trifluoromethyl group can also be used.

Examples of sulfonate type photo acid generator may include: bis (phenylsulfonyl) methane, bis (4-methyl phenylsulfonyl) methane, bis (2-naphthyl sulfonyl) methane, 2,2-bis (phenylsulfonyl) propane, 2,2-bis (4-methyl phenylsulfonyl) propane, 2,2-bis (2-naphthyl sulfonyl) propane, 2-methyl-2-(p-toluene sulfonyl) propiophenone, 2-(cyclohexyl carbonyl)-2-(p-toluene sulfonyl) propane, 2,4-dimethyl-2-(p-toluene sulfonyl) pentane-3-one, etc.

Examples of glyoxime derivative type photo acid generator may include: bis-O-(p-toluene sulfonyl)-α-dimethylglyoxime, bis-O-(p-toluene sulfonyl)-α-diphenyl glyoxime, bis-O-(p-toluene sulfonyl)-α-dicyclohexyl glyoxime, bis-O-(p-toluene sulfonyl)-2,3-pentanedione glyoxime, bis-O-(p-toluene sulfonyl)-2-methyl-3,4-pentanedione glyoxime, bis-O-(n-butane sulfonyl)-α-dimethylglyoxime, bis-O-(n-butane sulfonyl)-α-diphenyl glyoxime, bis-O-(n-butane sulfonyl)-α-dicyclohexyl glyoxime, bis-O-(n-butane sulfonyl)-2,3-pentanedione glyoxime, bis-O-(n-butane sulfonyl)-2-methyl-3,4-pentanedione glyoxime, bis-O-(methane sulfonyl)-α-dimethylglyoxime, bis-O-(trifluoromethane sulfonyl)-α-dimethylglyoxime, bis-O-(1,2,1-trifluoro ethane sulfonyl)-α-dimethylglyoxime, bis-O-(tert-butane sulfonyl)-α-dimethylglyoxime, bis-O-(perfluoro octane sulfonyl)-α-dimethylglyoxime, bis-O-(cyclohexyl sulfonyl)-α-dimethylglyoxime, bis-O-(benzene sulfonyl)-α-dimethylglyoxime, bis-O-(p-fluorobenzene sulfonyl)-α-dimethylglyoxime, bis-O-(p-tert-butylbenzene sulfonyl)-α-dimethylglyoxime, bis-O-(xylene sulfonyl)-α-dimethylglyoxime, bis-O-(camphor sulfonyl)-α-dimethylglyoxime, etc.

Among the above-mentioned acid generators, a sulfonium salt, bissulfonyl diazomethane and N-sulfonyl oxyimide are preferably used.

Although most suitable anion of generated acid is different depending on conditions like deprotection property of an acid labile group to be used in a polymer included in a base resin, anion without volatility and extremely high diffusion property are generally selected.

In this case, preferable anions are benzenesulfonic acid anion, toluenesulfonic acid anion, 4-(4-toluene sulfonyloxy) benzenesulfonic acid anion, pentafluoro benzenesulfonic acid anion, 2,2,2-trifluoro ethane sulfonic acid anion, nonafluoro butane sulfonic acid anion, heptadecafluoro octane sulfonic acid anion, camphor sulfonic acid anion, etc.

An amount of the acid generator to be added in a chemically amplified positive resist composition of the present invention is preferably 0 to 20 parts by mass, more preferably 1 to 10 parts by mass to 100 parts by mass of solid content in the resist composition. The acid generator can be used alone or in admixture. Furthermore, an acid generator with low transmittance at an exposure wavelength can be used, thereby transmittance of a resist film can be controlled with an addition amount of the acid generator.

The dissolution inhibitor blended in the positive resist composition of the present invention is preferably a compound which has a mass-average molecular weight of 100 to 1,000, and has two or more of a phenolic hydroxyl group in a molecular in which 10 to 100 mole% on average of hydrogen atoms of the phenolic hydroxyl groups are substituted with an acid labile group. In addition, a mass-average molecular weight of the compound is 100 to 1,000, preferably 150 to 800. An amount of the dissolution inhibitor to be added may be 0 to 50 parts by mass, preferably 5 to 50 parts by mass, more preferably 10 to 30 parts by mass to 100 parts by mass of a base resin. The dissolution inhibitor can be used alone or in admixture. If the amount of the dissolution inhibitor to be blended is in the range, film loss of pattern are hardly generated, and resolution can be improved.

Examples of such a dissolution inhibitor may include: bis (4-(2'-tetrahydropyranyl oxy) phenyl) methane, bis (4-(2'-tetrahydrofuranyl oxy) phenyl) methane, bis (4-tert-butoxyphenyl) methane, bis (4-tert-butoxy carbonyl oxy phenyl) methane, bis (4-tert-butoxy carbonyl methyl oxy phenyl) methane, bis (4-(1'-ethoxy ethoxy phenyl) methane, bis (4-(1'-ethoxy propyl oxy) phenyl) methane, 2,2-bis (4'-(2''-tetrahydropyranyl oxy)) propane, 2,2-bis (4'-(2''-tetrahydrofuranyl oxy) phenyl) propane, 2,2-bis (4'-tert-butoxyphenyl) propane, 2,2-bis (4'-tert-butoxy carbonyl oxy phenyl) propane, 2,2-bis (4'-tert-butoxy carbonyl methyl oxy phenyl) propane, 2,2-bis (4'-(1''-ethoxy ethoxy) phenyl) propane, 2,2-bis (4'-(1''-ethoxy propyl oxy) phenyl) propane, tertbutyl 4,4-bis (4'-(2''-tetrahydropyranyl oxy) phenyl) valerate, tertbutyl 4,4-bis (4'-(2''-tetrahydrofuranyl oxy) phenyl) valerate, tertbutyl 4,4-bis (4'-tert-butoxy phenyl) valerate, tertbutyl 4,4-bis (4'-tert-butoxy carbonyl oxy phenyl) valerate, tertbutyl 4,4-bis (4'-tert-butoxy carbonyl methyl oxy phenyl) valerate, tertbutyl 4,4-bis (4'-(1''-ethoxy ethoxy) phenyl) valerate, tertbutyl 4,4-bis (4'-(1''-ethoxy propyl oxy) phenyl) valerate, tris (4-(2'-tetrahydropyranyl oxy) phenyl) methane, tris (4-(2'-tetrahydrofuranyl oxy) phenyl) methane, tris (4-tert-butoxyphenyl) methane, tris (4-tert-butoxy carbonyl oxy phenyl) methane, tris (4-tert-butoxy carbonyl oxy methyl phenyl) methane, tris (4-(1'-ethoxy ethoxy) phenyl) methane, tris (4-(1'-ethoxy propyl oxy) phenyl) methane, 1,1,2-tris (4'-(2''-tetrahydropyranyl oxy) phenyl) ethane, 1,1,2-tris (4'-(2''-tetrahydrofuranyl oxy) phenyl) ethane, 1,1,2-tris (4'-tert-butoxy phenyl) ethane, 1,1,2-tris (4'-tert-butoxy carbonyl oxy phenyl) ethane, 1,1,2-tris (4'-tert-butoxy carbonyl methyl oxy phenyl) ethane, 1,1,2-tris (4'-(1'-ethoxy ethoxy) phenyl) ethane, 1,1,2-tris (4'-(2'-ethoxy propyl oxy) phenyl) ethane, etc.

A suitable basic compound blended with a positive resist composition of the present invention is a compound which can suppress a diffusion rate of the acid generated from an acid generator when the acid is diffused in a resist film. If such a basic compound is blended, a diffusion rate of acid in a resist film can be suppressed, and thereby resolution is improved, fluctuation of sensitivity after exposure can be suppressed, dependency on a substrate or on environment can be lowered, and exposure margin, pattern profile, etc. can be improved.

Examples of such a basic compound may include: a primary, secondary and tertiary aliphatic amines, a mixed amine, an aromatic amine, a heterocyclic amine, a compound containing nitrogen which has a carboxyl group, a compound containing nitrogen which has a sulfonyl group, a compound containing nitrogen which has a hydroxyl group, a compound containing nitrogen which has a hydroxy phenyl group, an alcoholic compound containing nitrogen, an amide derivative, an imide derivative, etc.

Illustrative examples of the primary aliphatic amine may include: ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, tetraethylenepentamine, etc.

Examples of the secondary aliphatic amine may include: dimethylamine, diethylamine, di-n-propylamine, diisopropyl amine, di-n-butylamine, diisobutylamine, di-sec-butylamine, dipentylamine, dicyclopentyl amine, dihexylamine, dicyclohexylamine, diheptylamine, dioctylamine, dinonylamine, didecylamine, didodecylamine, dicetylamine, N,N-dimethyl methylenediamine, N,N-dimethyl ethylenediamine, N,N-dimethyl tetraethylene pentamine, etc.

Examples of the tertiary aliphatic amine may include: trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetra methyl methylene diamine, N,N,N',N'-tetramethyl ethylenediamine, N,N,N',N'-tetramethyl tetraethylene pentamine, etc.

Examples of the mixed amines include: dimethylethyl amine, methylethylpropyl amine, benzyl amine, phenethyl amine, benzyl dimethyl amine, etc.

Examples of the aromatic amines and the heterocyclic amines may include: an aniline derivative (for example, aniline, N-methyl aniline, N-ethyl aniline, N-propyl aniline, N,N-dimethylaniline, 2-methyl aniline, 3-methyl aniline, 4-methyl aniline, ethyl aniline, propyl aniline, trimethyl aniline, 2-nitroaniline, 3-nitroaniline, 4-nitroaniline, 2,4-dinitro aniline, 2,6-dinitro aniline, 3,5-dinitro aniline, N,N-dimethyl toluidine, etc.), diphenyl (p-tolyl) amine, methyl diphenylamine, triphenylamine, phenylenediamine, naphthylamine, diamino naphthalene, a pyrrole derivative (for example, pyrrole, 2H-pyrrole, 1-methyl pyrrole, 2,4-dimethyl pyrrole, 2,5-dimethyl pyrrole, N-methyl pyrrole, etc.), oxazole derivatives (for example, oxazole, isoxazole, etc.), a thiazoles derivative (for example, thiazole, isothiazole, etc.), an imidazole derivative (for example, imidazole, 4-methyl imidazole, 4-methyl-2-phenyl imidazole, etc.), a pyrazole derivative, a furazane derivative, a pyrroline derivative (for example, pyrroline, 2-methyl-1-pyrroline, etc.), a pyrrolidine derivative (for example, pyrrolidine, N-methyl pyrrolidine, pyrrolidinone, N-methyl pyrrolidone, etc.), an imidazoline derivative, an imidazolidine derivative, a pyridine derivative (for example, pyridine, methyl pyridine, ethyl pyridine, propyl pyridine, butyl pyridine, 4-(1-butyl pentyl) pyridine, dimethyl pyridine, trimethyl pyridine, triethyl pyridine, phenyl pyridine, 3-methyl-2-phenyl pyridine, 4-tert-butyl pyridine, diphenyl pyridine, benzyl pyridine, methoxy pyridine, butoxy pyridine, dimethoxy pyridine, 1-methyl-2-pyridine, 4-pyrrolidino pyridine, 1-methyl-4-phenyl pyridine, 2-(1-ethylpropyl) pyridine, amino pyridine, dimethyl amino pyridine, etc.), a pyridazine derivative, a pyrimidine derivative, a pyrazine derivative, a pyrazoline derivative, a pyrazolidine derivative, a piperidine derivative, a piperazine derivative, a morpholine derivative, an indole derivative, an isoindole derivative, a 1H-indazole derivative, an indoline derivative, a quinoline derivative (for example, quinoline, 3-quinoline carbonitrile, etc.), an isoquinoline derivative, a cinnoline derivative, a quinazoline derivative, a quinoxaline derivative, a phthalazine derivative, a purine derivative, a pteridine derivative, a carbazole derivative, a phenanthridine derivative, an acridine derivative, a phenazine derivative, 1,10-phenanthroline derivative, an adenine derivative, an adenosine derivative, a guanine derivative, a guanosine derivative, a uracil derivative, a uridine derivative, etc.

Furthermore, examples of a compound containing nitrogen which has a carboxyl group may include: aminobenzoic acid, indole carboxylic acid, and an amino acid derivative (for example, nicotinic acid, alanine, arginine, aspartic acid, glutamic acid, glycine, histidine, isoleucine, glycyl leucine, leucine, methionine, phenylalanine, threonine, lysine, 3-aminopyrazine-2-carboxylic acid, methoxy alanine, etc.).

Examples of a compound containing nitrogen which has a sulfonyl group may include: 3-pyridine sulfonic acid, pyridinium p-toluenesulfonate, etc.

Examples of a compound containing nitrogen which has a hydroxyl group, a compound containing nitrogen which has a hydroxy phenyl group, and an alcoholic compound containing nitrogen may include: 2-hydroxy pyridine, amino cresol, 2,4-quinoline diol, 3-indole methanol hydrate, monoethanolamine, diethanolamine, triethanolamine, N-ethyl diethanolamine, N,N-diethyl ethanolamine, triisopropanol amine, 2,2'-iminodiethanol, 2-amino ethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidine ethanol, 1-(2-hydroxy ethyl)pyrrolidine, 1-(2-hydroxyethyl)-2-pyrrolidinone, 3-piperidino-1,2-propanediol, 3-pyrrolidino-1,2-propanediol, 8-hydroxy julolidine, 3-quinuclidinol, 3-tropanol, 1-methyl-2-pyrrolidine ethanol, 1-aziridine ethanol, N-(2-hydroxyethyl) phthalimide, N-(2-hydroxyethyl) isonicotinamide, etc.

Examples of an amide derivative may include: formamide, N-methyl formamide, N,N-dimethylformamide, acetamide, N-methyl acetamide, N,N-dimethylacetamide, propionamide, benzamide, etc.

Examples of an imide derivative may include: phthalimide, succinimide, maleimide, etc.

Furthermore, one or more selected from the basic compound represented by the following general formula (B)-1 can also be added.

N(X)ₙ(Y)₃₋ₙ (B)-1

In the formula (B)-1, n is 1, 2, or 3. The side chain X may be the same or different, and represents the following general formulae (X)-1 to (X)-3. The side chain Y may be the same or different, and represents a hydrogen atom or a linear, branched or cyclic alkyl group having 1-20 carbon atoms which may comprise an ether group or a hydroxyl group. Moreover, X may bond to each other and form a ring.

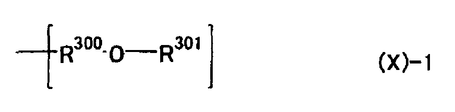

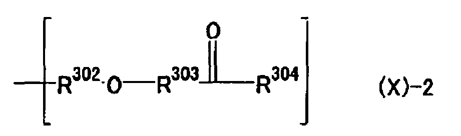

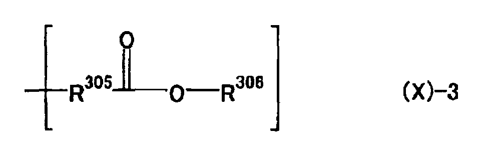

In the formulae (X)-1 to (X)-3, R³⁰⁰, R³⁰², and R³⁰⁵ independently represent a linear or branched alkylene group having 1-4 carbon atoms, and R³⁰¹ and R³⁰⁴ independently represent a hydrogen atom or a linear, branched or cyclic alkyl group having 1-20 carbon atoms, which may comprise one or more of a hydroxy group, an ether group, an ester group, and a lactone ring.

R³⁰³ represents a single bond, or a linear or branched alkylene group having 1-4 carbon atoms, and R³⁰⁶ represents a linear, branched or cyclic alkyl group having 1-20 carbon atoms, which may contain one or more of a hydroxy group, an ether group, an ester group, and a lactone ring.

Illustrative examples of the compound represented by the general formula (B)-1 may be as follows:
Tris (2-methoxy methoxy ethyl) amine, tris {2-(2-methoxyethoxy) ethyl} amine, tris{2-(2-methoxy ethoxy methoxy) ethyl} amine, tris {2-{1-methoxyethoxy) ethyl} amine, tris {2-(1-ethoxy ethoxy) ethyl} amine, tris {2-(1-ethoxy propoxy) ethyl} amine, tris [2-{2-(2-hydroxy ethoxy) ethoxy} ethyl] amine, 4,7,13,16,21,24-hexaoxa -1,10-diazabicyclo [8.8.8] hexacosane, 4,7,13,18-tetraoxa-1,10-diazabicyclo [8.5.5] eicosane,1,4,10,13-tetraoxa-7,16-diazabicyclo octadecane, 1-aza-12-crown-4, 1-aza-15-crown-5, 1-aza-18-crown-6, tris (2-formyloxy-ethyl) amine, tris (2-acetoxy ethyl) amine, tris (2-propionyloxy-ethyl)amine, tris (2-butylyloxy-ethyl)amine, tris(2-isobutyryl oxy-ethyl) amine, tris (2-valeryloxy-ethyl) amine, tris (2-pivaloyloxy-ethyl) amine, N,N-bis(2-acetoxy ethyl) 2-(acetoxyacetoxy) ethylamine, tris (2-methoxycarbonyl oxy-ethyl) amine, tris (2-tert-butoxy carbonyl oxy-ethyl) amine, tris [2-(2-oxo propoxy) ethyl] amine, tris [2-(methoxycarbonyl methyl) oxy-ethyl] amine, tris [2-(tert-butoxycarbonylmethyloxy) ethyl] amine, tris [2-(cyclohexyloxy carbonylmethyloxy) ethyl] amine, tris (2-methoxycarbonyl ethyl) amine, tris (2-ethoxy carbonyl ethyl) amine, N,N-bis (2-hydroxy ethyl) 2-(methoxycarbonyl) ethylamine, N,N-bis (2-acetoxy ethyl) 2-(methoxycarbonyl) ethylamine, N,N-bis (2-hydroxy ethyl) 2-(ethoxy carbonyl) ethylamine, N,N-bis (2-acetoxy ethyl) 2-(ethoxy carbonyl) ethylamine, N,N-bis (2-hydroxy ethyl) 2-(2-methoxy ethoxy carbonyl) ethylamine, N,N-bis (2-acetoxy ethyl) 2-(2-methoxy ethoxy carbonyl) ethylamine, N,N-bis (2-hydroxy ethyl) 2-(2-hydroxy ethoxy carbonyl) ethylamine, N,N-bis (2-acetoxy ethyl) 2-(2-acetoxy ethoxy carbonyl) ethylamine, N,N-bis(2-hydroxy ethyl) 2-[(methoxycarbonyl) methoxycarbonyl] ethylamine, N,N-bis(2-acetoxy ethyl) 2-[(methoxycarbonyl) methoxycarbonyl] ethylamine, N,N-bis (2-hydroxy ethyl) 2-(2-oxo propoxy carbonyl) ethylamine, N,N-bis (2-acetoxy ethyl) 2-(2-oxo propoxy carbonyl) ethylamine, N,N-bis (2-hydroxy ethyl) 2-(tetrahydro furfuryl oxy-carbonyl) ethylamine, N,N-bis (2-acetoxy ethyl) 2-(tetrahydro furfuryl oxy-carbonyl) ethylamine, N,N-bis (2-hydroxy ethyl) 2-[(2-oxo tetrahydrofuran-3-yl )oxy-carbonyl] ethylamine, N,N-bis (2-acetoxy ethyl) 2-[(2-oxo-tetrahydrofuran-3-yl )oxy-carbonyl] ethylamine, N,N-bis (2-hydroxy ethyl) 2-(4-hydroxy butoxy carbonyl) ethylamine, N,N-bis (2-formyl oxy-ethyl) 2-(4-formyloxybutoxy carbonyl) ethylamine, N,N-bis (2-formyl oxy-ethyl) 2-(2-formyloxy ethoxy carbonyl) ethylamine, N,N-bis (2-methoxy ethyl) 2-(methoxycarbonyl) ethylamine, N-(2-hydroxy ethyl) bis [2-(methoxycarbonyl) ethyl] amine, N-(2-acetoxy ethyl) bis [2-(methoxycarbonyl) ethyl] amine, N-(2-hydroxy ethyl) bis [2-(ethoxy carbonyl) ethyl] amine, N-(2-acetoxy ethyl) bis [2-(ethoxy carbonyl) ethyl] amine, N-(3-hydroxy-1-propyl) bis [2-(methoxycarbonyl) ethyl] amine, N-(3-acetoxy-1-propyl) bis [2-(methoxycarbonyl) ethyl] amine, N-(2-methoxy ethyl) bis [2-(methoxycarbonyl) ethyl] amine, N-butylbis [2-(methoxycarbonyl) ethyl] amine, N-butylbis [2-(2-methoxy ethoxy carbonyl) ethyl] amine, N-methyl bis (2-acetoxy ethyl) amine, N-ethyl bis (2-acetoxy ethyl) amine, N-methyl bis (2-pivaloyloxy-ethyl) amine, N-ethyl bis [2-(methoxy carbonyloxy) ethyl] amine, N-ethyl bis [2-(tert-butoxycarbonyloxy) ethyl] amine, tris (methoxycarbonyl methyl) amine, tris (ethoxy carbonyl methyl) amine, N-butyl bis (methoxycarbonyl methyl) amine, N-hexyl bis (methoxycarbonyl methyl) amine, and β-(diethylamino)-δ-valerolactone, etc. However they are not limited thereto.

In addition, the basic compound can be used alone or in admixture. And the blending amount thereof is 0 to 2 parts by mass to 100 parts by mass of a solid content of a resist composition, in particular, preferably 0.01 to 1 parts by mass. If the blending amount is more than 2 parts by mass, sensitivity may be degraded too much.

A surfactant can be further added to a positive resist composition of the present invention to improve an application property.

The surfactant is not limited. Examples thereof may include: nonionic surfactants such as polyoxyethylene alkyl ethers, such as polyoxyethylene lauryl ether, polyoxyethylene stearyl ether, polyoxyethylene cetyl ether, polyoxyethylene olein ether, etc.; polyoxyethylene alkyl aryl ethers such as polyoxyethylene octyl-phenol ether, polyoxyethylene nonyl phenol ether, etc.; polyoxyethylene polyoxy propylene block copolymers; sorbitan fatty acid esters such as sorbitan monolaurate, sorbitan monopalmitate, sorbitan monostearate, etc.; and polyoxyethylene sorbitan fatty acid esters such as polyoxyethylene sorbitan monolaurate, polyoxyethylene sorbitan monopalmitate, polyoxyethylene sorbitanmonostearate, polyoxyethylene sorbitan trioleate, polyoxyethylene sorbitan tristearate; fluorinated surfactants such as EFTOP EF301, EF303 and EF352 (Tochem), MEGAFACE F171, F172, and F173 (manufactured by Dainippon Ink Industry), Fluorad FC-430, FC-431 (manufactured by Sumitomo 3M), and Asahiguard AG710, Surflon S-381, S-382, SC101, SC102, SC103, SC104, SC105 and SC106, Surfynol E1004, KH-10, KH-20, KH-30 and KH-40 (manufactured by Asahi Glass Co., Ltd.), etc., organo siloxane polymer KP-341, X-70-092, X-70-093 (manufactured by Shin-Etsu Chemical Co., Ltd.), acrylic or methacrylic POLYFLOW No.75, No.95 (KYOEISHA CHEMICAL), etc. Among them, FC430, Surflon S-381, Surfynol E1004, KH-20 and KH-30 are preferable. These can be used alone or in combination of two or more of them.

An amount of the surfactant to be added in a positive resist composition of the present invention is preferably two parts by mass or less, more preferably one parts by mass or less to 100 parts by mass of solid content in the resist composition.

In the case of using such a positive resist composition of the present invention to produce various integrated circuits, known lithography technique can be used to form a pattern on a substrate. However, it is not limited thereto. Among the patterning process, for example, the present invention provides a patterning process mentioned below.

Namely, it is a patterning process comprising, at least, a step of applying the positive resist composition of the present invention on a substrate, a step of exposing the applied resist composition to high energy beam after heat-treatment, and a step of developing the exposed resist composition by using a developer.

In the step of applying a positive resist composition on a substrate, the resist composition of the present invention is applied on a substrate for manufacture of integrated circuits (Si, SiO₂, SiN, SiON, TiN, WSi, BPSG, SOG, an organic antireflection coating, etc.), by an appropriate coating method such as spin coating method, roll coating method, flow coating method, DIP coating method, spray coating method, doctor coating method, etc. so that the thickness of the coating film is 0.1 to 2.0 µm.

In the subsequent heat-treatment, the substrate is prebaked on a hot plate at 60 to 150 °C for 1 to 10 minutes, preferably at 80-120 °C for 1 to 5 minutes.

Subsequently, in the step of exposing the applied resist composition to high energy beam, the intended pattern is exposed through a predetermined mask with light source selected from ultraviolet ray, far ultraviolet ray, electron beam, X-ray, excimer lasers, γ ray, synchrotron-radiation, etc., preferably at an exposure wavelength of 300 nm or less. At this time, the exposure is preferably carried out so that the exposure dose is about 1 - 200 mJ/cm², more preferably about 10 - 100 mJ/cm². After exposure, post exposure baking (PEB) may be conducted at 60-150 °C for 1 to 5 minutes, preferably at 80-120 °C for 1 to 3 minutes on a hot plate.

Furthermore, in the step of development with a developer, development is conducted with using a developer of an aqueous alkaline solution such as 0.1 to 5 %, preferably 2 - 3 % tetramethylammonium hydroxide (TMAH), etc. for 0.1 - 3 minutes, preferably for 0.5 - 2 minutes according to a conventional method, such as the dip method, the puddle method, the spray method, etc.

A desired pattern on a substrate is formed after the above-mentioned steps are conducted.

In the patterning process of the present invention, of course, development may be conducted after heat treatment following exposure, and other various processes, such as an etching process, a resist removing process, a cleaning process etc. may be performed.

In addition, the positive resist composition of the present invention is suitable for micropatterning especially with a high-energy beam such as a far ultraviolet ray at a wavelength of 254 - 193 nm, a vacuum ultraviolet radiation at a wavelength of 157 nm, electron beam, soft X ray, X-ray, excimer lasers, y ray, synchrotron-radiation, among high energy beams.

### EXAMPLES

Although Synthetic examples, Comparative synthetic examples, Examples, and Comparative examples will be shown and the present invention will be explained in detail hereafter, the present invention is not restricted to the following Examples.

### [Synthetic Example 1]

To 1L flask were added 101.1 g of 4-ethoxy ethoxy styrene, 38.9g of 4-t-butoxy carbonyl styrene, and 520 g of toluene as a solvent. This reaction vessel was cooled to - 70 °C under nitrogen atmosphere, and degasing under reduced pressure and nitrogen flowing were repeated 3 times. 9.59 g of AIBN (2,2'-azobisisobutyronitril) was added as a polymerization initiator after elevating to a room temperature, and then it was elevated to 62 °C and reacted for 20 hours. Into this reaction solution was dropped a mixed solution of 1200 mL of methanol and 50 mL of water and the solution was mixed. Then, the solution was stirred for 15 minutes. After kept on standing for 2 hours, the underlayer (the polymer layer) was isolated. The obtained polymer layer was concentrated, therein 400 mL of tetrahydrofuran, 350 mL of methanol and 3.0 g of oxalic acid were added. Then it was elevated to 40 °C and deprotection reaction was conducted for 40 hours. The solution was neutralized with 4.0 g of pyridine. After concentrating the reaction solution, it was dissolved in 225 g of tetrahydrofuran and 370 g of methanol. And into the solution was dropped 1000 g of hexane and it was mixed. Then, the solution was stirred for 15 minutes. After kept on standing for 2 hours, the underlayer (the polymer layer) was isolated. The obtained polymer layer was concentrated, and dissolved in 0.25 L of acetone. Then, this solution was precipitated and washed in 10.0 L of water, the obtained white solid was taken by filtration and then dried under reduced pressure at 40 °C, and 78.7 g of white polymer was obtained.

The obtained polymer was analyzed by ¹³C, ¹H-NMR, GPC measurement, and measurement of transmittance at the 248 nm wavelength light with a film thickness of 10000Å, and the following results were obtained.
Copolymerization ratio
4-hydroxy styrene : 4-t-butoxy carbonyl styrene = 72.8 : 27.2
Mass average-molecular-weight (Mw) = 13700
Molecular weight distribution (Mw/Mn) = 1.85
Transmittance = 4.8%

Furthermore, the structural formula is shown below.

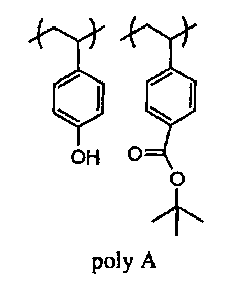

This polymer is defined as "poly A".

### [Synthetic Example 2]

To 1L flask were added 152.8 g of 4-ethoxy ethoxy styrene, 39.4g of 4-t-amyloxy styrene, 17.8g of 4-t-butoxy carbonyl styrene, and 600 g of toluene as a solvent. This reaction vessel was cooled to -70 °C under nitrogen atmosphere, and degasing under reduced pressure and nitrogen flowing were repeated 3 times. 12.5 g of AIBN was added as a polymerization initiator after elevating to a room temperature, and then it was elevated to 61 °C and reacted for 20 hours. Into this reaction solution was dropped a mixed solution of 1000 mL of methanol and 120 mL of water and the solution was mixed. Then, the solution was stirred for 15 minutes. After kept on standing for 2 hours, the underlayer (the polymer layer) was isolated.
The obtained polymer layer was concentrated, therein 580 mL of tetrahydrofuran, 470 mL of methanol and 4.5 g of oxalic acid were added. Then it was elevated to 40 °C and deprotection reaction was conducted for 40 hours. The solution was neutralized with 6.0 g of pyridine. After concentrating the reaction solution, it was dissolved in 225 g of tetrahydrofuran and 370 g of methanol. And into the solution was dropped 1000 g of hexane and it was mixed. Then, the solution was stirred for 15 minutes. After kept on standing for 2 hours, the underlayer (the polymer layer) was isolated. The obtained polymer layer was concentrated, and dissolved in 0.30 L of acetone. Then, this solution was precipitated and washed in 10.0 L of water, the obtained white solid was taken by filtration and then dried under reduced pressure at 40 °C, and 124.9 g of white polymer was obtained.

The obtained polymer was analyzed by ¹³C, ¹H-NMR, GPC measurement, and measurement of transmittance at the 248 nm wavelength light with a film thickness of 10000Å, and the following results were obtained.
Copolymerization ratio
4-hydroxy styrene : 4-t-amyloxy styrene : 4-t-butoxy carbonyl styrene = 72.7 : 19.3 : 8.0
Mass average-molecular-weight (Mw) = 12200
Molecular weight distribution (Mw/Mn) = 1.88
Transmittance = 9.2%

Furthermore, the structural formula is shown below.

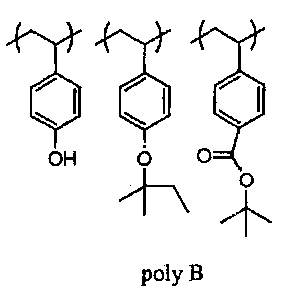

This polymer is defined as "poly B".

### [Synthetic Example 3]

To 1L flask were added 151.1 g of 4-ethoxy ethoxy styrene 47.8g of 4-t-amyloxy styrene, 11.1g of 4-t-butoxy carbonyl styrene, and 600 g of toluene as a solvent. This reaction vessel was cooled to -70 °C under nitrogen atmosphere, and degasing under reduced pressure and nitrogen flowing were repeated 3 times. 12.5 g of AIBN was added as a polymerization initiator after elevating to a room temperature, and then it was elevated to 61 °C and reacted for 20 hours. Into this reaction solution was dropped a mixed solution of 1000 mL of methanol and 120 mL of water and the solution was mixed. Then, the solution was stirred for 15 minutes. After kept on standing for 2 hours, the underlayer (the polymer layer) was isolated.
The obtained polymer layer was concentrated, therein 580 mL of tetrahydrofuran, 470 mL of methanol and 4.5 g of oxalic acid were added. Then it was elevated to 40 °C and deprotection reaction was conducted for 40 hours. The solution was neutralized with 6.0 g of pyridine. After concentrating the reaction solution, it was dissolved in 225 g of tetrahydrofuran and 370 g of methanol. And into the solution was dropped 1000 g of hexane and it was mixed. Then, the solution was stirred for 15 minutes. After kept on standing for 2 hours, the underlayer (the polymer layer) was isolated. The obtained polymer layer was concentrated, and dissolved in 0.30 L of acetone. Then, this solution was precipitated and washed in 10.0 L of water, the obtained white solid was taken by filtration and then dried under reduced pressure at 40 °C, and 118.7 g of white polymer was obtained.

The obtained polymer was analyzed by ¹³C, ¹H-NMR, GPC measurement, and measurement of transmittance at the 248 nm wavelength light with a film thickness of 10000Å, and the following results were obtained.
Copolymerization ratio
4-hydroxy styrene : 4-t-amyloxy styrene : 4-t-butoxy carbonyl styrene = 72.6 : 22.5 : 4.9
Mass average-molecular-weight (Mw) = 11600
Molecular weight distribution (Mw/Mn) =1.85
Transmittance = 21.3%

Furthermore, the structural formula is shown below.

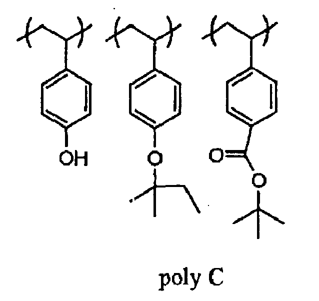

This polymer is defined as "poly C".

### [Synthetic Example 4]

To 1L flask were added 153.0 g of 4-ethoxy ethoxy styrene, 33.2g of 4-t-amyloxy styrene, 17.8g of 4-t-butoxy carbonyl styrene, 6.0 g of 1-ethyl cyclopentyl methacrylate and 600 g of toluene as a solvent. This reaction vessel was cooled to -70 °C under nitrogen atmosphere, and degasing under reduced pressure and nitrogen flowing were repeated 3 times. 12.5 g of AIBN was added as a polymerization initiator after elevating to a room temperature, and then it was elevated to 61 °C and reacted for 20 hours. Into this reaction solution was dropped a mixed solution of 1000 mL of methanol and 120 mL of water and the solution was mixed. Then, the solution was stirred for 15 minutes. After kept on standing for 2 hours, the underlayer (the polymer layer) was isolated. The obtained polymer layer was concentrated, therein 580 mL of tetrahydrofuran, 470 mL of methanol and 4.5 g of oxalic acid were added. Then it was elevated to 40 °C and deprotection reaction was conducted for 40 hours. The solution was neutralized with 6.0 g of pyridine. After concentrating the reaction solution, it was dissolved in 225 g of tetrahydrofuran and 370 g of methanol. And into the solution was dropped 1000 g of hexane and it was mixed. Then, the solution was stirred for 15 minutes. After kept on standing for 2 hours, the underlayer (the polymer layer) was isolated. The obtained polymer layer was concentrated, and dissolved in 0.30 L of acetone. Then, this solution was precipitated and washed in 10.0 L of water, the obtained white solid was taken by filtration and then dried under reduced pressure at 40 °C, and 96.6 g of white polymer was obtained.

The obtained polymer was analyzed by ¹³C, ¹H-NMR, GPC measurement, and measurement of transmittance at the 248 nm wavelength light with a film thickness of 10000Å, and the following results were obtained.
Copolymerization ratio
4-hydroxy styrene : 4-t-amyloxy styrene : 4-t-butoxy carbonyl styrene : 1-ethyl cyclopentyl methacrylate =
70.9 : 16.3 : 9.2 : 3.6
Mass average-molecular-weight (Mw) = 9700
Molecular weight distribution (Mw/Mn) = 1.77
Transmittance = 7.5%

Furthermore, the structural formula is shown below.

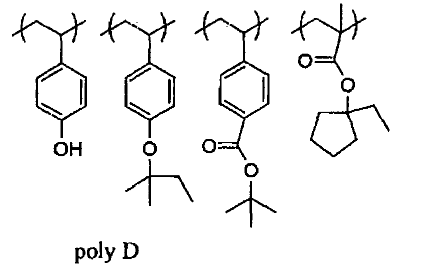

This polymer is defined as "poly D".

### [Synthetic Example 5]

To 1L flask were added 153.7 g of 4-ethoxy ethoxy styrene, 22.4g of 4-t-butoxy carbonyl styrene, 33.9 g of 1-ethyl cyclopentyl methacrylate and 600 g of toluene as a solvent. This reaction vessel was cooled to -70 °C under nitrogen atmosphere, and degasing under reduced pressure and nitrogen flowing were repeated 3 times. 12.6 g of AIBN was added as a polymerization initiator after elevating to a room temperature, and then it was elevated to 61 °C and reacted for 20 hours. Into this reaction solution was dropped a mixed solution of 1000 mL of methanol and 120 mL of water and the solution was mixed. Then, the solution was stirred for 15 minutes. After kept on standing for 2 hours, the underlayer (the polymer layer) was isolated.
The obtained polymer layer was concentrated, therein 580 mL of tetrahydrofuran, 470 mL of methanol and 4.5 g of oxalic acid were added. Then it was elevated to 40 °C and deprotection reaction was conducted for 40 hours. The solution was neutralized with 6.0 g of pyridine. After concentrating the reaction solution, it was dissolved in 225 g of tetrahydrofuran and 370 g of methanol. And into the solution was dropped 1000 g of hexane and it was mixed. Then, the solution was stirred for 15 minutes. After kept on standing for 2 hours, the underlayer (the polymer layer) was isolated. The obtained polymer layer was concentrated, and dissolved in 0.30 L of acetone. Then, this solution was precipitated and washed in 10.0 L of water, the obtained white solid was taken by filtration and then dried under reduced pressure at 40 °C, and 96.6 g of white polymer was obtained.

The obtained polymer was analyzed by ¹³C, ¹H-NMR, GPC measurement, and measurement of transmittance at the 248 nm wavelength light with a film thickness of 10000Å, and the following results were obtained.
Copolymerization ratio
4-hydroxy styrene : 4-t-butoxy carbonyl styrene : 1-ethyl cyclopentyl methacrylate = 73.1 : 9.8 : 17.1
Mass average-molecular-weight (Mw) = 10100
Molecular weight distribution (Mw/Mn) = 1.75
Transmittance = 7.0%

Furthermore, the structural formula is shown below.

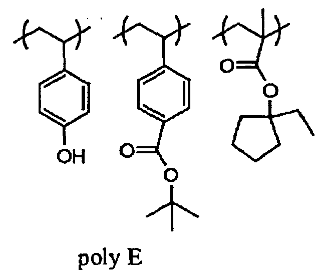

This polymer is defined as "poly E".

### [Synthetic Example 6]

After 2L flask of reaction vessel was dried under reduced pressure, 1500 g of a tetrahydrofuran solution distilled and dehydrated was added therein under nitrogen atmosphere and this vessel was cooled to -75 °C. Then, 12.8 g of s-butyllithium (cyclohexane solution : 1N) was added, and a mixed solution of 101.1 g of p-ethoxy ethoxy styrene distilled and dehydrated with metallic sodium and 38.9 g of 4-t-amyloxy styrene treated with the same way was dropped therein. At this time, an inside temperature of a reaction solution was watched not to be -65 °C or more. After it was reacted for 30 minutes, 10 g of methanol was added to inhibit the reaction. The solution was elevated to a room temperature and the obtained reaction solution was concentrated under reduced pressure. And the following process were repeated three times to purge metallic lithium: To this solution was added 800 g of methanol, kept on standing, and then methanol layer of upper layer was removed. After the process, the polymer solution of under layer was concentrated, therein 840 mL of tetrahydrofuran, 630 mL of methanol and 3.2 g of oxalic acid were added. Then it was elevated to 40 °C and deprotection reaction was conducted for 20 hours. The solution was neutralized with 35 g of pyridine. After concentrating the reaction solution, it was dissolved in 0.6 L of acetone. Then, it was precipitated and washed in 7.0 L of water, the obtained white solid was taken by filtration and then dried under reduced pressure at 40 °C, and 93.7 g of white polymer was obtained.

The obtained polymer was analyzed by ¹³C, ¹H-NMR, GPC measurement, and measurement of transmittance at the 248 nm wavelength light with a film thickness of 10000 Å, and the following results were obtained.
Copolymerization ratio
4-hydroxy styrene : 4-t-amyloxy styrene = 71.8 : 28.2
Mass average-molecular-weight (Mw) = 9600
Molecular weight distribution (Mw/Mn) = 1.06
Transmittance = 74.2%

Furthermore, the structural formula is shown below.

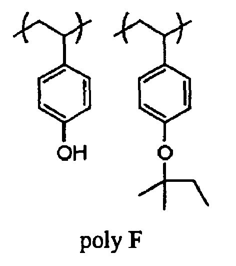

This polymer is defined as "poly F".

### [Comparative Synthetic Example 1]

To 2L flask were added 71.5 g of 4-acetoxy styrene, 22.4g of 4-t-amyloxy styrene, 9.2 g of 1-ethyl cyclopentyl methacrylate and 200 g of toluene as a solvent. This reaction vessel was cooled to -70 °C under nitrogen atmosphere, and degasing under reduced pressure and nitrogen flowing were repeated 3 times. 3.9 g of AIBN was added as a polymerization initiator after elevating to a room temperature, and then it was elevated to 60 °C and reacted for 15 hours. This reaction solution was concentrated to be a half volume, the solution was precipitated in a mixed solution of 4.5 L of methanol and 0.5 L of water. The obtained white solid was taken by filtration and then dried under reduced pressure at 60 °C, and 89 g of white polymer was obtained. The polymer was dissolved again in 0.27 L of methanol and 0.27 L of tetrahydrofuran, and 77g of triethylamine and 14 g of water was added to conduct deprotection reaction. The solution was neutralized with acetic acid. After concentrating the reaction solution, it was dissolved in 0.5 L of acetone. Then, precipitation, filtration and drying were conducted the same way as mentioned above, and 55 g of white polymer was obtained.

The obtained polymer was analyzed by ¹³C, ¹H-NMR, GPC measurement, and measurement of transmittance at the 248 nm wavelength light with a film thickness of 10000Å, and the following results were obtained.
Copolymerization ratio
4-hydroxy styrene : 4-t-amyloxy styrene : 1-ethyl cyclopentyl methacrylate = 70.3 : 21.9 : 7.8
Mass average-molecular-weight (Mw) = 17000
Molecular weight distribution (Mw/Mn) = 1.70
Transmittance = 72.7%

Furthermore, the structural formula is shown below.

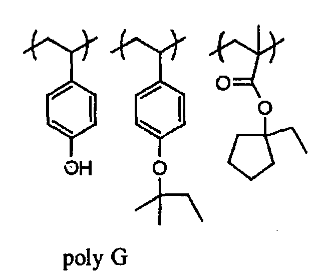

This polymer is defined as "poly G".

### (Examples 1 - 6, Comparative Eamples 1, 2)

### [Preparation of resist compositions]

Here, the relationship between a ratio of 4-t-butoxy carbonyl styrene (BCS) in the synthesized polymer and transmittance at the 248 nm wavelength light with a film thickness of 10000Å was investigated. The result was shown in the Fig.1.

From the Fig.1, it proves that if a ratio of BCS is 1 - 10 % , in particular, 3 - 6 %, transmittance can be about 10 - 60 %, in particular, 20 - 50 %.

And, when two or more types of polymers were blended with the positive resist composition hereafter, transmittance at the 248 nm wavelength light with a film thickness of 10000Å was adjusted to be 10 - 50 % in reference to the graph of Fig.1.

Resist compositions were prepared according to compositions shown in the following Tables 1 and 2.
(1) Polymer
   poly A - poly G : Synthetic Examples 1 - 6 and Comparative Synthetic Example 1
(2) Acid generator
   PAG1: triphenyl sulfonium trifluoromethane sulfonate
   PAG2: bis (cyclohexylsulfonyl) diazomethane
   PAG3: bis (2,4-dimethyl benzene sulfonyl) diazomethane
(3) Basic compound
   Basic compound A: tris (2-methoxy methoxy ethyl) amine
(4) Surfactant
   Surfactant A: FC-430 (manufactured by Sumitomo 3M)
   Surfactant B: Surflon S-381 (manufactured by Asahi Glass Co., Ltd.),
(5) Organic solvent
   solvent A: propylene glycol methyl ether acetate
   solvent B: ethyl lactate

In addition, a ratio (%) of BCS in the Tables 1 and 2, means a ratio of 4-t-butoxy carbonyl styrene in all repeating units.

**[Table 1]**

| Composition | Example 1 | Example 2 | Example 3 | Example 4 |
|---|---|---|---|---|
| poly A | 15 | - | - | - |
| poly B | - | - | - | 30 |
| poly C | - | 80 | 80 | - |
| poly F | 65 | - | - | 50 |
| a ratio of BCS (%) | 5.08% | 4.90% | 4.90% | 5.00% |
| PAG1 | - | - | 1.5 | - |
| PAG2 | 5 | 4 | 3 | 4 |
| PAG3 | 1 | 1.5 | - | 1.5 |
| Basic compound A | 0.2 | 0.2 | 0.2 | 0.2 |
| Surfactant A | 0.07 | 0.07 | 0.07 | 0.07 |
| Surfactant B | 0.07 | 0.07 | 0.07 | 0.07 |
| SolventA | 600 | 600 | 600 | 600 |
| Solvent B | - | - | - | - |

**[Table 2]**

| Composition | Example 5 | Example 6 | Comparative Eample 1 | Comparative Eample 2 |
|---|---|---|---|---|
| poly D | 40 | 30 | - | - |
| poly E | - | - | - | - |
| poly F | 40 | 50 | 80 | - |
| poly G | - | - | - | 80 |
| a ratio of BCS(%) | 4.60% | 3.68% | 0.00% | 0.00% |
| PAG1 | 1 | 1 | - | 2.5 |
| PAG2 | 4 | 4 | 5 | 4 |
| PAG3 | 1 | 1 | 3.5 | 1.5 |
| Basic compound A | 0.2 | 0.2 | 0.2 | 0.2 |
| Surfactant A | 0.07 | 0.07 | 0.07 | 0.07 |
| Surfactant B | 0.07 | 0.07 | 0.07 | 0.07 |
| Solvent A | 540 | 540 | 600 | 540 |
| Solvent B | 60 | 60 | - | 60 |

### [Formation of resist pattern]

After each of the resist composition prepared above (Examples 1 - 6 and Comparative examples 1, 2) was filtrated with a filter of 0.03µm made of PTFE (polytetrafluoroethylene), each resist solution was applied onto a silicon wafer (an SiO₂ substrate) by spin coating method to form a resist film with a thickness of 3500Å.

Then, the silicon wafers (SiO₂ substrates) on which resist films were formed were baked at 120 °C for 90 seconds on a hot plate. Furthermore, the wafers were exposed using the excimer laser stepper (NSR-S203B, NA = 0.68, σ 0.60, normal illumination manufactured by Nikon), baked (PEB: post exposure bake) at 120 °C for 90 seconds, and developed for 60 seconds in 2.38 % aqueous solution of tetramethylammonium hydroxide, to give positive resist pattern.

### [Evaluation of resist pattern]

The obtained resist pattern was evaluated as follows.

An exposure dose when 0.18 µm line and space pattern was able to be resolved in 1:1 was determined as the optimum exposure dose (sensitivity : Eop), and the minimum line and space pattern size which could be resolved at the exposure dose was determined as resolution of the resist to be evaluated. Moreover, resolved pattern profile was observed in section with a scanning electron microscope. As for observation of pattern profile and generation of a standing wave, excellent pattern was described as excellent, comparatively trapezoid pattern was described as comparatively defective, trapezoid pattern was described as defective, and generation of a standing wave was described as ×, Δ, ○ in decreasing order.

These results of evaluation were shown in the following Table 3.

**[Table 3]**

| Example and Comparative Eample | sensitivity (mJ/cm²) | resolution (µm) | pattern profile | a standing wave | transmittance of a used polymer |
|---|---|---|---|---|---|
| Example 1 | 22 | 0.16 | excellent | ○ | 19.3% |
| Example 2 | 21 | 0.16 | excellent | Δ | 21.3% |
| Example 3 | 19 | 0.15 | excellent | ○ | 21.3% |
| Example 4 | 20 | 0.15 | excellent | ○ | 20.0% |
| Example 5 | 21 | 0.15 | excellent | ○ | 22.3% |
| Example 6 | 20 | 0.16 | excellent | Δ | 34.5% |
| Comparative | 18 | 0.17 | comparatively | × | 74.2% |
| Eample 1 | | | defective | | |
| Comparative | 25 | 0.18 | defective | Δ | 72.7% |
| Eample 2 | | | | | |

In addition, in the section of "transmittance of a used polymer" of Table 3, when two or more of polymers were combined and used, transmittance at the 248 nm wavelength light with a film thickness of 10000Å with a ratio of combination in the Tables 1 and 2 is shown.

As shown in the Table 3, the positive resist compositions of the Examples 1 - 6 have high sensitivity, high resolution and an excellent pattern profile, and generation of a standing wave can be suppressed sufficiently.

In addition, the present invention is not limited to the embodiment described above. The above-described embodiment is mere an example, and those having substantially the same structure as technical ideas described in the appended claims and providing the similar functions and advantages are included in the scope of the present invention.

## Claims

1. A positive resist composition wherein at least a polymer included in a base resin has a repeating unit with an acid labile group having absorption at the 248 nm wavelength light and the repeating unit is included with a ratio of 1-10% of all repeating units of polymers included in the base resin.

2. The positive resist composition according to Claim 1 in which the repeating unit with an acid labile group having absorption at the 248 nm wavelength light is represented by a following general formula (1), 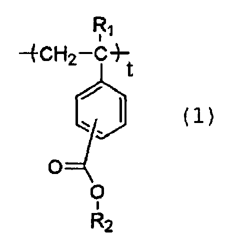 ,wherein R₁ represents a hydrogen atom or a methyl group, R₂ represents a tertiary alkyl group or an alkoxy alkyl group having 4-20 carbon atoms, and t satisfies t>0.

3. The positive resist composition according to Claim 1 or Claim 2 in which the base resin further includes repeating units represented by a following general formula (2), 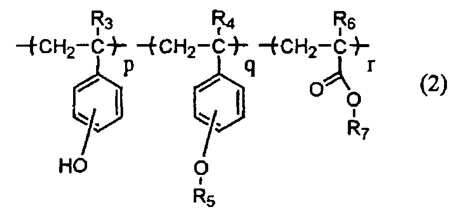 ,wherein R₃, R₄ and R₆ independently represents a hydrogen atom or a methyl group, R₅ represents any one of a tertiary alkyl group, an alkoxy alkyl group, an alkoxy carbonyl group and an alkoxy carbonyl alkyl group having 4-20 carbon atoms, R₇ represents a tertiary alkyl group having 4-20 carbon atoms, p satisfies p>0, and q and r satisfy q≧0 and r≧0.

4. The positive resist composition according to Claim 2 or Claim 3 wherein the repeating unit represented by the general formula (1) is included with a ratio of 3-6% of all the repeating units of polymers included in the base resin.

5. The positive resist composition according to any one of Claims 1-4 wherein the base resin has 10-60% transmittance at the 248 nm wavelength light with a film thickness of 10000Å.

6. The positive resist composition according to any one of Claims 1-5 which further contains an organic solvent and an acid generator to serve as a chemically amplified resist composition.

7. The positive resist composition according to Claim 6 which further contains a basic compound.

8. A patterning process comprising, at least, a step of applying the positive resist composition according to any one of Claims 1-7 on a substrate, a step of exposing the applied resist composition to high energy beam after heat-treatment, and a step of developing the exposed resist composition by using a developer.
